# EUROPEAN PATENT APPLICATION

(11) **EP 4 651 687 A1**
(43) Date of publication of application: **19.11.2025**
(21) Application number: 25175853.8
(22) Date of filing: 12.05.2025
(51) Int. Cl.: H10K 50/15, H10K 50/852, H10K 59/80, H10K 102/00

(54) **ORGANIC LIGHT-EMITTING ELEMENT, ORGANIC LIGHT-EMITTING DISPLAY APPARATUS AND ELECTRONIC DEVICE INCLUDING THE SAME**

(30) Priority: 13.05.2024 KR 20240062733
(71) Applicant: Samsung Display Co., Ltd., Yongin-si, Gyeonggi-do 17113 (KR)
(72) Inventor: KIM, Soungwook, 17113 Yongin-si (KR); KIM, Daewon, 17113 Yongin-si (KR); SHIN, Hyun, 17113 Yongin-si (KR); LEE, Bora, 17113 Yongin-si (KR); SUH, Duckjong, 17113 Yongin-si (KR); SHIN, Hyosup, 17113 Yongin-si (KR)
(74) Representative: Marks & Clerk LLP

(57) **Abstract**

Provided are an organic light-emitting element, and an organic light-emitting display apparatus comprising the same, the organic light-emitting element including a first electrode and a second electrode facing each other, an organic emission layer between the first electrode and the second electrode, a hole transport layer between the first electrode and the organic emission layer, and metal nanoparticles above the first electrode, wherein a first distance between the organic emission layer and a lower surface of the metal nanoparticles is less than a distance between the organic emission layer and the second electrode.

## Description

### BACKGROUND

### 1. Field

One or more embodiments relate to an organic light-emitting element and an organic light-emitting display apparatus with improved light-extraction efficiency and lifespan.

### 2. Description of the Related Art

Generally, a display apparatus includes a light-emitting element, and pixel circuits configured to control electrical signals applied to the light-emitting element. The pixel circuits include a thin-film transistor (TFT), a capacitor, and a plurality of wirings. The light-emitting element is configured to emit light in response to an electrical signal transferred from the wirings.

An organic light-emitting display apparatus includes an organic light-emitting element including a hole injection electrode, an electron injection electrode, and an organic emission layer therebetween. The organic light-emitting display apparatus is a self-luminous display apparatus in which light is emitted while excitons fall from an excited state to a ground state, the excitons being created when holes injected from the hole injection electrode combine with electrons injected from the electron injection electrode in the organic emission layer.

An organic light-emitting display apparatus, which is a self-luminous display apparatus, does not require a separate light source, and thus, may be driven at a relatively low voltage. In addition, such an organic light-emitting display apparatus may be configured to have a lightweight thin profile and high-quality characteristics, such as a wide viewing angle, high contrast, fast response speed, and the like, and thus, is in the limelight as a next-generation display apparatus.

### SUMMARY

One or more embodiments include an organic light-emitting display apparatus including an organic light-emitting element with improved light-extraction efficiency and lifespan. However, such an aspect is an example, and the disclosure is not limited thereto.

Additional aspects will be set forth in part in the description which follows and, in part, will be apparent from the description, or may be learned by practice of the presented embodiments of the disclosure.

According to one or more embodiments, an organic light-emitting element includes a first electrode and a second electrode facing each other, an organic emission layer between the first electrode and the second electrode, a hole transport layer between the first electrode and the organic emission layer, and metal nanoparticles above the first electrode, wherein a first distance between the organic emission layer and a lower surface of the metal nanoparticles is less than a distance between the organic emission layer and the second electrode.

The first distance may be a first resonance distance with respect to intensity of light generated in the organic emission layer.

The first distance may be about 100 Å to about 400 Å.

The organic light-emitting element may further include a metal reflective layer above the second electrode, wherein a second distance between an upper surface of the first electrode and a lower surface of the metal reflective layer is about 1,500 Å to about 2,000 Å.

The organic light-emitting element may further include a low refractive index layer above the second electrode, and having a refractive index that is less than a refractive index of the second electrode, wherein the second electrode includes a transparent conductive oxide, and provides an upper reflective layer together with the low refractive index layer.

The organic light-emitting element may further include an electron transport layer between the organic emission layer and the second electrode, wherein a thickness of the hole transport layer is less than a thickness of the electron transport layer.

The organic light-emitting element may further include a lower reflective layer between the first electrode and the metal nanoparticles.

A distance between the organic emission layer and an upper surface of the first electrode may be a second resonance distance with respect to intensity of light generated in the organic emission layer.

The organic light-emitting element may further include a metal reflective layer above the second electrode, wherein a distance between an upper surface of the first electrode and a lower surface of the metal reflective layer is about 2,800 Å to about 3,200 Å.

The organic light-emitting element may further include a lower reflective layer between the first electrode and the metal nanoparticles.

According to one or more embodiments, an organic light-emitting display apparatus includes a plurality of pixels including an organic light-emitting element and at least one thin-film transistor, the organic light-emitting element including a first electrode and a second electrode facing each other, an organic emission layer between the first electrode and the second electrode, a hole transport layer between the first electrode and the organic emission layer, and metal nanoparticles above the first electrode, wherein a first distance between the organic emission layer and a lower surface of the metal nanoparticles is less than a distance between the organic emission layer and the second electrode.

The first distance may be a first resonance distance with respect to intensity of light generated in the organic emission layer.

The organic light-emitting display apparatus may further include a low refractive index layer above the second electrode, and having a refractive index that is less than a refractive index of the second electrode, wherein the second electrode includes a transparent conductive oxide, and provides an upper reflective layer together with the low refractive index layer.

The organic light-emitting display apparatus may further include an electron transport layer between the organic emission layer and the second electrode, wherein a thickness of the hole transport layer is less than a thickness of the electron transport layer.

The organic light-emitting display apparatus may further include a lower reflective layer between the first electrode and the metal nanoparticles.

According to one or more embodiments, an electronic device comprises a display apparatus including an organic light-emitting element, the organic light-emitting element including a first electrode and a second electrode facing each other, an organic emission layer between the first electrode and the second electrode, a hole transport layer between the first electrode and the organic emission layer, and metal nanoparticles above the first electrode, wherein a first distance between the organic emission layer and a lower surface of the metal nanoparticles is less than a distance between the organic emission layer and the second electrode.

The first distance may be a first resonance distance with respect to intensity of light generated in the organic emission layer.

The electronic device may further include a low refractive index layer above the second electrode, and having a refractive index that is less than a refractive index of the second electrode, wherein the second electrode includes a transparent conductive oxide, and provides an upper reflective layer together with the low refractive index layer.

The electronic device may further include an electron transport layer between the organic emission layer and the second electrode, wherein a thickness of the hole transport layer is less than a thickness of the electron transport layer.

The electronic device may further include a lower reflective layer between the first electrode and the metal nanoparticles.

At least some of the above and other features of the invention are set out in the claims.

### BRIEF DESCRIPTION OF THE DRAWINGS

The above and other aspects of certain embodiments of the disclosure will be more apparent from the following description taken in conjunction with the accompanying drawings, in which:
FIG. 1 is a schematic plan view of an organic light-emitting display apparatus according to one or more embodiments;
FIG. 2A is an equivalent circuit diagram of a sub-pixel of a display apparatus according to one or more embodiments;
FIG. 2B is an equivalent circuit diagram of a sub-pixel of a display apparatus according to one or more embodiments;
FIG. 3 is a schematic cross-sectional view of a portion of an organic light-emitting display apparatus according to one or more embodiments;
FIG. 4 is a schematic view of a stack structure of an organic light-emitting display element according to one or more embodiments;
FIG. 5 is a schematic view of an organic light-emitting display apparatus according to one or more embodiments; and
FIG. 6 is a schematic view of a stack structure of an organic light-emitting display apparatus according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meanings, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, are inclusive of the stated value and mean within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

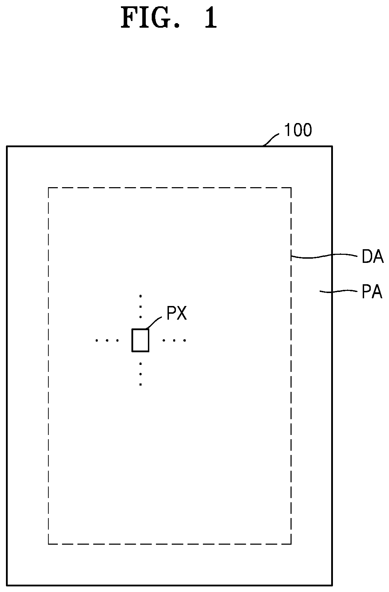

FIG. 1 is a schematic plan view of an organic light-emitting display apparatus according to one or more embodiments.

A plurality of pixels PX may be arranged in a display area DA of a substrate 100, wherein the pixels PX each include an organic light-emitting element OLED. Each of the pixels PX may denote a sub-pixel, and the pixel PX may be configured to emit, for example, red, green, blue, or white light. The pixel PX may be implemented by an organic light-emitting element, and the organic light-emitting element may be driven by a pixel circuit connected thereto. The pixel circuit may include a plurality of thin-film transistors and a storage capacitor. The number of thin-film transistors included in one pixel circuit may be one to seven. However, various modifications may be made.

The edge of the display area DA may have a shape similar to a rectangle or a square as a whole. Accordingly, the substrate 100 may also have a shape similar to a rectangle or a square as a whole. The edge of the display area DA may have a shape, such as a circular shape, an elliptical shape, or a polygonal shape.

Various wirings configured to transfer electrical signals to be applied to the display area DA may be arranged in a peripheral area PA of the substrate 100. A thin-film transistor may be also provided in the peripheral area PA. In this case, the thin-film transistor arranged in the peripheral area PA may be a portion of a circuit portion configured to control electrical signals applied into the display area DA.

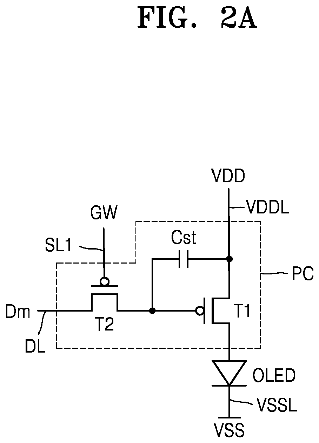

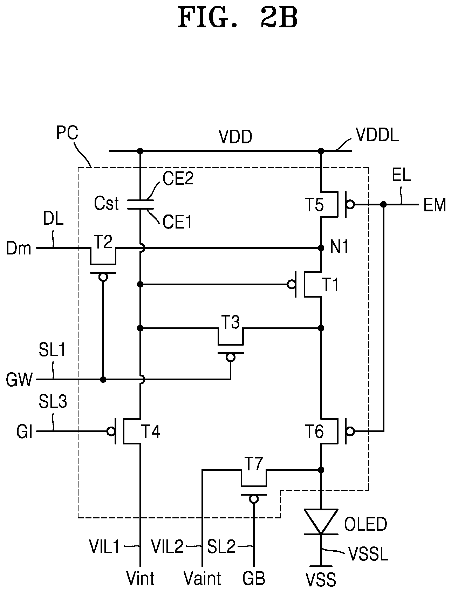

FIGS. 2A and 2B are equivalent circuit diagrams of a sub-pixel of a display apparatus according to one or more embodiments.

Referring to FIG. 2A, an organic light-emitting element OLED corresponding to a sub-pixel may be electrically connected to a pixel circuit PC, and the pixel circuit PC may include a first transistor T1, a second transistor T2, and a storage capacitor Cst. The pixel circuit PC may be electrically connected to signal lines and voltage lines. The signal lines may include a gate line, such as a first scan line SL1, and a data line DL, and the voltage line may include a first voltage line VDDL.

The second transistor T2 may be electrically connected to the first scan line SL1 and the data line DL. The first scan line SL1 may be configured to provide a first scan signal GW to a gate electrode of the second transistor T2. The second transistor T2 may be configured to transfer a data signal Dm to the first transistor T1 according to a first scan signal GW input from the first scan line SL1, wherein the data signal Dm is input from the data line DL.

The storage capacitor Cst may be electrically connected to the second transistor T2 and a first voltage line VDDL, and may be configured to store a voltage corresponding to a difference between a voltage transferred from the second transistor T2 and a first power voltage VDD supplied by the first voltage line VDDL.

The first transistor T1 is a driving transistor and is configured to control a driving current flowing through the organic light-emitting element OLED. The first transistor T1 may be connected to the first voltage line VDDL and the storage capacitor Cst. The first transistor T1 may be configured to control the driving current flowing from the first voltage line VDDL to the organic light-emitting element OLED in response to the voltage stored in the storage capacitor Cst. The organic light-emitting element OLED may be configured to emit light having a corresponding brightness (e.g., preset brightness) corresponding to the driving current. A first electrode of the organic light-emitting element OLED may be electrically connected to the first transistor T1, and a second electrode may be electrically connected to a second voltage line VSSL configured to supply a second power voltage VSS.

Although it is shown in FIG. 2A that the pixel circuit PC includes two transistors and one storage capacitor, the pixel circuit PC may include three or more transistors.

Referring to FIG. 2B, the pixel circuit PC may include the first transistor T1, the second transistor T2, a third transistor T3, a fourth transistor T4, a fifth transistor T5, a sixth transistor T6, a seventh transistor T7, and the storage capacitor Cst.

The pixel circuit PC may be electrically connected to signal lines and voltage lines. The signal lines may include the first scan line SL1, a second scan line SL2, a third scan line SL3, a gate line, such as an emission control line EL, and the data line DL. The voltage lines may include first and second initialization voltage lines VIL1 and VIL2, and the first voltage line VDDL.

The first voltage line VDDL may be configured to transfer the first power voltage VDD to the first transistor T1. The first initialization voltage line VIL1 may be configured to transfer a first initialization voltage Vint to the pixel circuit PC, wherein the first initialization voltage Vint initializes the first transistor T1. The second initialization voltage line VIL2 may be configured to transfer a second initialization voltage Vaint to the pixel circuit PC, wherein the second initialization voltage Vaint initializes the first electrode of the organic light-emitting element OLED.

The first transistor T1 may be electrically connected to the first voltage line VDDL through the fifth transistor T5, and electrically connected to the organic light-emitting element OLED through the sixth transistor T6. The first transistor T1 serves as the driving transistor, receives a data signal Dm, and supplies the driving current to the light-emitting element OLED according to a switching operation of the second transistor T2.

The second transistor T2 is a data-write transistor, and is electrically connected to the first scan line SL1 and the data line DL. The second transistor T2 may be electrically connected to the first voltage line VDDL through the fifth transistor T5. The second transistor T2 is turned on according to a first scan signal GW transferred through the first scan line SL1, and performs a switching operation of transferring a data signal Dm to a first node N1, the data signal Dm being transferred through the data line DL.

The third transistor T3 may be electrically connected to the first scan line SL1 and electrically connected to the organic light-emitting element OLED through the sixth transistor T6. The third transistor T3 may be turned on according to a first scan signal GW to diode-connect the first transistor T1, wherein the first scan signal GW is transferred through the first scan line SL1.

The fourth transistor T4 is a first initialization transistor and is electrically connected to the third scan line SL3 and the first initialization voltage line VIL1. The fourth transistor T4 may be turned on according to a third scan signal GI to initialize the voltage of a gate electrode of the first transistor T1 by transferring the first initialization voltage Vint from the first initialization voltage line VIL1 to the gate electrode of the first transistor T1, wherein the third scan signal GI is transferred through the third scan line SL3. A third scan signal GI may correspond to a first scan signal of another pixel circuit arranged in a previous row of the relevant pixel circuit PC.

The fifth transistor T5 may be an operation control transistor, and the sixth transistor T6 may be an emission control transistor. The fifth transistor T5 and the sixth transistor T6 may be electrically connected to an emission control line EL, concurrently or substantially simultaneously turned on according to an emission control signal EM transferred through the emission control line EL, and may form a current path such that the driving current flows in a direction from the first voltage line VDDL to the light-emitting element OLED.

The seventh transistor T7 serves as a second initialization transistor, and may be electrically connected to the second scan line SL2, the second initialization voltage line VIL2, and the sixth transistor T6. The seventh transistor T7 is turned on according to a second scan signal GB transferred through the second scan line SL2, and is configured to transfer the second initialization voltage Vaint from the second initialization voltage line VIL2 to the first electrode of the organic light-emitting element OLED, thereby initializing the first electrode of the organic light-emitting diode OLED.

The storage capacitor Cst may include a first storage electrode CE1 and a second storage electrode CE2. The first storage electrode CE1 is electrically connected to the gate electrode of the first transistor T1, and the second storage electrode CE2 is electrically connected to the first voltage line VDDL. The storage capacitor Cst may maintain a voltage applied to the gate electrode of the first transistor T1 by storing and maintaining a voltage corresponding to a difference between voltages of two opposite ends of the gate electrode of the first transistor T1 and the first voltage line VDDL.

Although it is shown in FIG. 2B that the plurality of transistors T1, T2, T3, T4, T5, T6, and T7 are P-type transistors, the disclosure is not limited thereto. At least one of the plurality of transistors T1, T2, T3, T4, T5, T6, and T7 may be an N-type transistor. However, various modifications may be possible.

In one or more embodiments, at least one of the plurality of transistors T1, T2, T3, T4, T5, T6, or T7 may include a semiconductor layer including oxide, and one or more of the other transistors may include a semiconductor layer including silicon. As an example, the third transistor T3 and the fourth transistor T4 may include an oxide semiconductor layer, and the rest of the transistors may include a silicon semiconductor layer. However, the disclosure is not limited thereto. All of the plurality of transistors T1, T2, T3, T4, T5, T6, and T7 may include a silicon semiconductor layer.

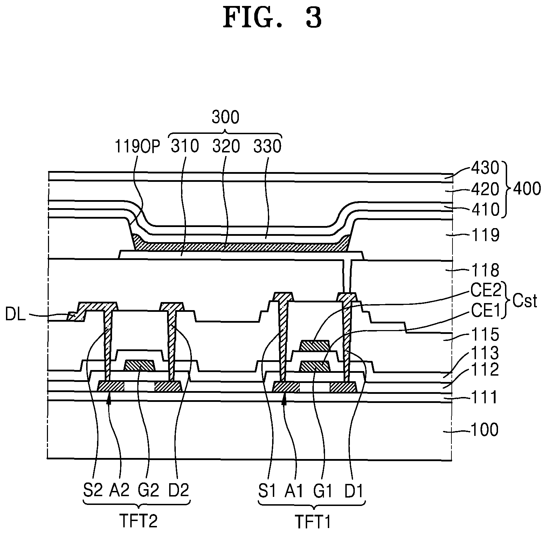

FIG. 3 is a schematic cross-sectional view of an organic light-emitting display apparatus according to one or more embodiments.

Referring to FIG. 3, the organic light-emitting display apparatus includes the substrate 100, thin-film transistors TFT1 and TFT2 located on the substrate 100, and an organic light-emitting element 300 electrically connected to the thin-film transistors TFT1 and TFT2 (as used herein, "located on" may mean "above"). In addition, the organic light-emitting display apparatus may further include various insulating layers 111, 112, 113, 115, 118, and 119, and the storage capacitor Cst.

The substrate 100 may include various materials, such as glass, metal, plastic or the like. In one or more embodiments, in the case where the substrate 100 is flexible, the substrate 100 may include a polymer resin including polyethersulphone (PES), polyacrylate (PAR), polyetherimide (PEI), polyethylene naphthalate (PEN), polyethylene terephthalate (PET), polyphenylene sulfide (PPS), polyarylate, polyimide (PI), polycarbonate (PC), or cellulose acetate propionate (CAP).

A buffer layer 111 may be located on the substrate 100, may reduce or block penetration of foreign materials, moisture, or external air from below the substrate 100, and may provide a flat surface on the substrate 100. The buffer layer 111 may include an inorganic material, an organic material, or an organic/inorganic composite material, and may include a single layer or a multi-layer including an inorganic material and an organic material, the inorganic material including oxide or nitride. In one or more embodiments, a barrier layer may be further located between the substrate 100 and the buffer layer 111, the barrier layer for reducing or blocking penetration of external air. In one or more embodiments, the buffer layer 111 may include silicon oxide (SiO₂) or silicon nitride (SiNₓ).

The first thin-film transistor TFT1 and/or the second thin-film transistor TFT2 may be located on the buffer layer 111. The first thin-film transistor TFT1 includes a semiconductor layer A1, a gate electrode G1, a source electrode S1, and a drain electrode D1. The second thin-film transistor TFT2 includes a semiconductor layer A2, a gate electrode G2, a source electrode S2, and a drain electrode D2.

The first thin-film transistor TFT1 may be connected to the organic light-emitting element 300 to serve as a driving thin-film transistor configured to drive the organic light-emitting element 300. The second thin-film transistor TFT2 may be connected to the data line DL to serve as a switching thin-film transistor. Although two thin-film transistors are shown in the drawing, the present disclosure is not limited thereto. The number of thin-film transistors may be variously modified.

The semiconductor layers A1 and A2 may include amorphous silicon or polycrystalline silicon. In one or more other embodiments, the semiconductor layers A1 and A2 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), or zinc (Zn). The semiconductor layers A1 and A2 may include a channel region, a source region, and a drain region, the source region and the drain region being doped with impurities.

The gate electrodes G1 and G2 are located over the semiconductor layers A1 and A2 with the first gate-insulating layer 112 therebetween. The gate electrodes G1 and G2 may include at least one of molybdenum (Mo), aluminium (Al), copper (Cu), titanium (Ti), or the like, and may include a single layer or a multi-layer. As an example, the gate electrodes G1 and G2 may include a single Mo layer.

The first gate-insulating layer 112 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO₂).

The second gate-insulating layer 113 may be provided to cover the gate electrodes G1 and G2. The second gate-insulating layer 113 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO₂).

The first storage electrode CE1 of the storage capacitor Cst may overlap the first thin-film transistor TFT1. As an example, the gate electrode G1 of the first thin-film transistor TFT1 may serve as the first storage electrode CE1 of the storage capacitor Cst. However, the disclosure is not limited thereto. The storage capacitor Cst might not overlap the first thin-film transistor TFT1, but may be apart from the first and second thin-film transistors TFT1 and TFT2.

The second storage electrode CE2 of the storage capacitor Cst overlaps the first storage electrode CE1 with the second gate-insulating layer 113 therebetween. In this case, the second gate-insulating layer 113 may serve as a dielectric layer of the storage capacitor Cst. The second storage electrode CE2 may include a conductive material including molybdenum (Mo), aluminium (Al), copper (Cu), and/or titanium (Ti) and may have a single-layered structure or a multi-layered structure including the above materials. As an example, the second storage electrode CE2 may be a single Mo layer or a multi-layer of Mo/Al/Mo.

The interlayer insulating layer 115 is formed on the entire surface of the substrate 100 to cover the second storage electrode CE2. The interlayer insulating layer 115 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO₂).

The source electrodes S1 and S2 and the drain electrodes D1 and D2 are located on the interlayer insulating layer 115. The source electrodes S1 and S2 and the drain electrodes D1 and D2 may each include a conductive material including molybdenum (Mo), aluminium (Al), copper (Cu), and/or titanium (Ti), and may include a single layer or a multi-layer including the above materials. As an example, the source electrodes S1 and S2 and the drain electrodes D1 and D2 may have a multi-layered structure of Ti/Al/Ti.

The planarization layer 118 may be located on the source electrodes S1 and S2 and the drain electrodes D1 and D2, and the organic light-emitting element 300 may be located on the planarization layer 118. The organic light-emitting element 300 includes a first electrode 310, an intermediate layer 320, and a second electrode 330, wherein the intermediate layer 320 includes an organic emission layer.

The planarization layer 118 may have a flat upper surface, such that the first electrode 310 is formed to be substantially flat. The planarization layer 118 may include a single layer or a multi-layer including an organic material or an inorganic material. The planarization layer 118 may include a general-purpose polymer, such as benzocyclobutene (BCB), polyimide, hexamethyldisiloxane (HMDSO), polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, and/or a blend thereof. The planarization layer 118 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO₂). After the planarization layer 118 is formed, chemical mechanical polishing may be performed to provide a flat upper surface.

There is an opening in the planarization layer 118 that exposes one of the source electrode S1 and the drain electrode D1 of the first thin-film transistor TFT1. The first electrode 310 is electrically connected to the first thin-film transistor TFT1 by being in contact with the source electrode S1 or the drain electrode D1 through the opening.

The pixel-defining layer 119 may be located on the first electrode 310. The pixel-defining layer 119 defines a pixel by including an opening 119OP corresponding to each sub-pixel, that is, the opening 119OP exposing at least a central portion of the first electrode 310. In addition, the pixel-defining layer 119 may reduce or prevent the likelihood of arcs and the like occurring between the edge of the first electrode 310 and the second electrode 330 by increasing a distance between the edge of the first electrode 310 and the second electrode 330. The pixel-defining layer 119 may include, for example, an organic material, such as polyimide or hexamethyldisiloxane (HMDSO).

In one or more embodiments, a spacer may be located on the pixel-defining layer 119. The spacer may be intended to reduce or prevent the likelihood of mask chopping that may occur during a mask process required for forming the intermediate layer 320 of the organic light-emitting element 300. The spacer may include an organic material, such as polyimide or hexamethyldisiloxane (HMDSO). The spacer may include the same material as a material of the pixel-defining layer 119, and may be concurrently or substantially simultaneously formed with the pixel-defining layer 119. In this case, a half-tone mask may be used.

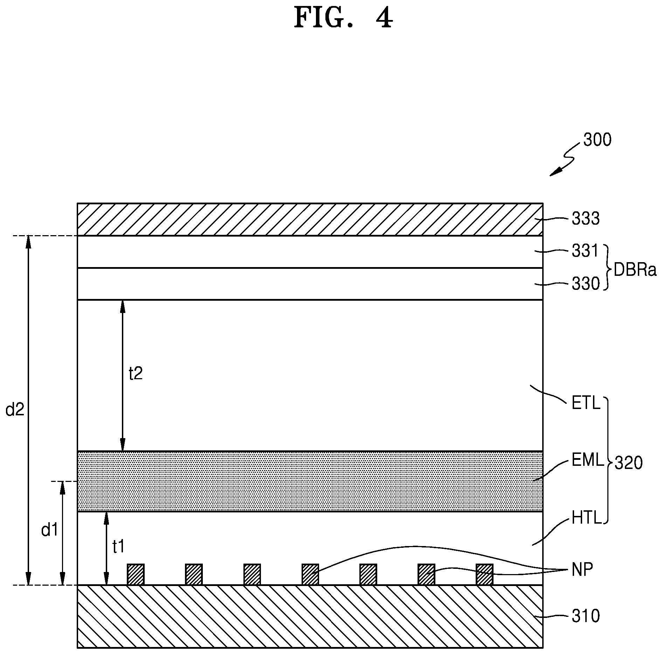

The intermediate layer 320 of the organic light-emitting element 300 may include an organic emission layer EML (see FIG. 4). The organic emission layer may include an organic material including a fluorescent or phosphorous material configured to emit red, green, blue, or white light. The organic emission layer may include a polymer organic material or a low molecular weight organic material. Functional layers may be selectively further located under and on the organic emission layer, the functional layers including a hole transport layer HTL, a hole injection layer (HIL), an electron transport layer ETL, and/or an electron injection layer (EIL). The intermediate layer 320 may be located to correspond to each of the plurality of first electrodes 310. However, the present disclosure is not limited thereto. The intermediate layer 320 may include a layer that is integral over the plurality of first electrodes 310. However, various modifications may be made.

The second electrode 330 may be a light-transmissive electrode or a reflective electrode. In one or more embodiments, the second electrode 330 may be a transparent or semi-transparent electrode, and may include a metal thin film including Li, Ca, LiF/Ca, LiF/Al, Al, Ag, Mg, or compound thereof and having a small work function. In addition, a transparent conductive oxide (TCO) layer, such as indium tin oxide (ITO), indium zinc oxide (IZO), ZnO, or In₂O₃ may be further located on the metal thin film. The second electrode 330 may be arranged over the display area DA and the peripheral area PA, and located on the intermediate layer 320 and the pixel-defining layer 119. The second electrode 330 may be integrally formed over the plurality of organic light-emitting elements 300 to correspond to the plurality of first electrodes 310. More specific configuration of the organic light-emitting element 300 according to one or more embodiments is described below.

A thin-film encapsulation layer 400 may be further located on the organic light-emitting element 300, wherein the thin-film encapsulation layer 400 is configured to encapsulate the display area DA. The thin-film encapsulation layer 400 may be configured to protect the organic light-emitting element 300 and the like from external moisture or oxygen by covering the display area DA. The thin-film encapsulation layer 400 may include a first inorganic encapsulation layer 410, an organic encapsulation layer 420, and a second inorganic encapsulation layer 430.

The first inorganic encapsulation layer 410 may cover the second electrode 330, and may include ceramic, metal oxide, metal nitride, metal carbide, metal oxynitride, indium oxide (In₂O₃), tin oxide (SnO₂), and/or indium tin oxide (ITO), silicon oxide, silicon nitride, and/or silicon oxynitride and the like. When needed, other layers including a capping layer may be located between the first inorganic encapsulation layer 410 and the second electrode 330. Because the first inorganic encapsulation layer 410 is formed along a structure thereunder, the upper surface of the first inorganic encapsulation layer 410 is not flat, as shown in FIG. 3.

The organic encapsulation layer 420 may cover the first inorganic encapsulation layer 410 and, unlike the first inorganic encapsulation layer 410, the upper surface of the organic encapsulation layer 420 may be approximately flat. For example, the upper surface of a portion of the organic encapsulation layer 420 that corresponds to the display area DA may be approximately flat. The organic encapsulation layer 420 may include at least one material among acryl, methacryl, polyester, polyethylene, polypropylene, polyethylene terephthalate (PET), polyethylene naphthalate, polycarbonate, polyimide, polyethylene sulfonate, polyoxymethylene, polyarylate, and/or hexamethyldisiloxane.

The second inorganic encapsulation layer 430 may cover the organic encapsulation layer 420, and may include ceramic, metal oxide, metal nitride, metal carbide, metal oxynitride, indium oxide (In₂O₃), tin oxide (SnO₂), and/or indium tin oxide (ITO), silicon oxide, silicon nitride, and/or silicon oxynitride and the like. Because the second inorganic encapsulation layer 430 is in contact with the first inorganic encapsulation layer 410 at the edge outside the display area DA, the organic encapsulation layer 420 may not be exposed to the outside.

Because the thin-film encapsulation layer 400 includes the first inorganic encapsulation layer 410, the organic encapsulation layer 420, and the second inorganic encapsulation layer 430, even when cracks occur inside the thin-film encapsulation layer 400, the cracks may not be connected between the first inorganic encapsulation layer 410 and the organic encapsulation layer 420, or between the organic encapsulation layer 420 and the second inorganic encapsulation layer 430, through the above multi-layered structure. With this configuration, forming of a path through which external moisture or oxygen penetrates the display area DA may be prevented or reduced.

Various functional layers, such as a touchscreen layer, a polarizing film, and the like may be further located on the upper portion of the thin-film encapsulation layer 400, and a capping layer configured to improve a light efficiency may be further located between the second electrode 330 and the thin-film encapsulation layer 400.

Hereinafter, a more specific configuration of the organic light-emitting element 300 according to one or more embodiments is described.

FIG. 4 is a view of a stack structure of the organic light-emitting element 300 according to one or more embodiments. Referring to FIG. 4, the organic light-emitting element 300 may include the first electrode 310, the intermediate layer 320, and the second electrode 330 that are sequentially stacked, and the intermediate layer 320 may include a hole transport layer HTL in which metal nanoparticles NP are located in the lower portion, an organic emission layer EML, and an electron transport layer ETL.

That is, the organic light-emitting element 300 according to one or more embodiments includes the first electrode 310 and the second electrode 330 facing each other, the organic emission layer EML located between the first electrode 310 and the second electrode 330, the hole transport layer HTL located between the first electrode 310 and the organic emission layer EML, and the metal nanoparticles NP located on the first electrode 310. In one or more embodiments, a first distance d1 between the organic emission layer EML (e.g., a point at or near the middle of the organic emission layer EML) and the lower surface of the metal nanoparticles NP may be less than a distance between the organic emission layer EML and the second electrode 330.

The first electrode 310 may serve as an anode electrode, and may include a material having a large work function to swiftly inject holes into the organic emission layer EML. The first electrode 310 may have a work function of about 4.0 eV to about 5.1 eV. The first electrode 310 may be a reflective electrode, a semi-transmissive electrode, or a transmissive electrode. In the case where the first electrode 310 includes a transmissive electrode, the first electrode 310 may include ITO, IZO, tin oxide (SnO₂), ZnO, In₂O₃, and/or the like. In the case where the first electrode 310 includes a reflective electrode, the first electrode 310 may include a reflective layer including Ag, Mg, Al, Pt, Pd, Au, Ni, Nd, Ir, Cr, or a compound thereof, and a transparent layer on the reflective layer and including ITO, IZO, ZnO, or In₂O₃. In one or more embodiments, the first electrode 310 may have a single layer or a multi-layered structure of two or more layers. As an example, the first electrode 310 may have a two-layered structure of ITO/Ag or a three-layered structure of ITO/Ag/ITO. The uppermost layer of the first electrode 310 includes ITO, a work function of ITO may be about 4.9 eV to about 5.1 eV. In this case, the work function of ITO may be adjusted by a plasma process.

The intermediate layer 320 includes the hole transport layer HTL including the metal nanoparticles NP in the lower portion, the organic emission layer EML, and the electron transport layer ETL.

The metal nanoparticles NP may be for extracting light in the direction to the second electrode 320, wherein the light is caused by surface plasmon occurring on the surface of the first electrode 310. The metal nanoparticles NP may be located in the lower portion of the hole transport layer HTL. Alternatively, it may be understood that the metal nanoparticles NP are located on the first electrode 310, and the hole transport layer HTL covers the metal nanoparticles NP.

The metal nanoparticles NP may include one of Ag, Au, Co, Cu, an alloy thereof, and a compound thereof. The metal nanoparticles NP may have a height and/or a width in the range of about 5 nm to about 500 nm. The metal nanoparticles NP may be apart from each other. The metal nanoparticles NP may be arranged periodically or aperiodically.

The metal nanoparticles NP may be formed by depositing metal and then etching the metal, and may be formed by depositing metal and then performing a heat-treating process. The deposition may be performed through chemical vapor deposition (CVD), for example, plasma enhanced CVD (PECVD). Conditions of the deposition (e.g., CVD or PECVD) are not particularly limited. The etching process may be a dry etching or wet etching process.

Even when the metal nanoparticles NP are located on the second electrode 320, light caused by the surface plasmons may be extracted. However, in the case where the metal nanoparticles NP are located on the second electrode 320, because the metal nanoparticles NP should be formed after the organic layers included in the organic light-emitting element 300 are formed, the organic light-emitting element 300 may be damaged during the process of forming the metal nanoparticles NP. Accordingly, in one or more embodiments, the metal nanoparticles NP may be located in the lower portion of the organic emission layer EML.

The hole transport layer HTL may be located to cover the metal nanoparticles NP. It may be understood that the metal nanoparticles NP are located in the lower portion of the hole transport layer HTL. The hole transport layer HTL may include known hole transport materials. As an example, the hole transport layer HTL may include carbazole-based derivatives, such as N-phenylcarbazole and polyvinylcarbazole, fluorine-based derivatives, and triphenylamine derivatives, such as TPD (N,N'-bis(3-methylphenyl)-N,N'-diphenyl) -[1,1-biphenyl]-4,4'-diamine), TCTA (4,4',4"-tris(carbazol-9-yl)triphenylamine), NPB (N,N'-di(1-naphthyl)-N,N'-diphenylbenzidine), or TAPC (4,4'-cyclohexylidene bis[N,N-bis(4-methylphenyl)benzenamine).

In one or more embodiments, a hole injection layer may be further included between the first electrode 310 and the emission layer EML. The hole injection layer may be located between the hole transport layer HTL and the emission layer EML, or located between the first electrode 310 and the hole transport layer HTL.

The hole injection layer may include at least one of phthalocyanine compounds, such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4 "-tris(3-methylphenylphenylamino)triphenylamine), TDATA (4,4'4"-Tris(N,N-diphenylamino)triphenylamine), 2TNATA (4,4',4"-tris{N,-(2-naphthyl) )-N-phenylamino}-triphenylamine), PEDOT/PSS (Poly(3,4-ethylenedioxythiophene)/Poly(4-styrenesulfonate)), PANI/DBSA (Polyaniline/Dodecylbenzenesulfonic acid), PANI/CSA(Polyaniline/Camphor sulfonic acid), or PANI/PSS ((Polyaniline)/Poly(4-styrenesulfonate)).

The hole transport layer HTL and the hole injection layer may be formed by using various methods, such as vacuum deposition, spin coating, a cast method, Langmuir-Blodgett, inkjet printing, a laser printing, a laser induced thermal imaging (LITI), and the like.

The organic emission layer EML may include a low-molecular or high-molecular weight material that emits fluorescence or phosphorescence. In the organic emission layer EML, holes and electrons injected into the first electrode 310 and the second electrode 330 recombine to form excitons, and while the excitons transition to the ground state, light is emitted. In this case, an emission wavelength, such as green, red, blue, and the like may be determined depending on a material used in the emission layer.

In one or more embodiments, the organic emission layer EML may include copper phthalocyanine (CuPc), (N,N'-Di(naphthalene-1-yl) )-N,N'-diphenyl-benzidine: NPB), tris-8-hydroxyquinoline aluminium (Alq3), PPV (Poly-Phenylenevinylene)-based material, or polyfluorene-based material. The organic emission layer EML may be formed by vacuum deposition, screen printing, inkjet printing, laser induced thermal imaging (LITI), or the like.

The electron transport layer ETL may be located between the organic emission layer EML and the second electrode 330. The electron transport layer ETL may include a material that may easily receive electrons from the second electrode 330. The electron transport layer ETL may include PBP (4-phenylbenzophenone), t-Bu-PBD (2-(biphenyl-4yl)-5-(4-tert-butylphenyl)-1,3,4-oxadiazole), 3TPYMB (tris- [3-(3-pyridyl)mesityl]borane) and B3PYMPM (bis-4,6-(3,5-di-3-pyridylphenyl)-2-methylpyrimidine). In one or more embodiments, an electron injection layer may be further located between the electron transport layer ETL and the second electrode 330.

The second electrode 330 is located on the electron transport layer ETL. To obtain a front emission apparatus, the second electrode 330 may include a transparent conductive oxide, such as ITO, IZO, ZnO, or In₂O₃. In one or more embodiments, the second electrode 330 may have a high refractive index. As an example, the second electrode 330 may have a refractive index of about 2 to about 3.

A low refractive index layer 331 having a low refractive index may be located on the second electrode 330. The low refractive index layer 331 may have a refractive index of about 1.2 to about 1.6. In one or more embodiments, the low refractive index layer 331 may include LiF. The second electrode 330 and the low refractive index layer 331 may have a stack structure of a high refractive index/low refractive index to serve as an upper reflective layer DBRa. The upper reflective layer DBRa may be a dispersion Bragg reflective layer. The upper reflective layer DBRa may further include a high refractive index layer and/or a low refractive index layer.

A metal reflective layer 333 may be located on the low refractive index layer 331. The metal reflective layer 333 may include aluminium (Al) or silver (Ag). The metal reflective layer 333 may be provided to be relatively very thin, and may serve as a semi-transmissive reflective layer.

In one or more embodiments, the organic emission layer EML may be located over the metal nanoparticles NP, and a vertical distance between 1/2 of the thickness of the organic emission layer EML and the lower surface of the metal nanoparticles NP may be set as the first distance d1. The first distance d1 may be a first resonance distance based on the intensity of light emitted in the organic emission layer EML. The first distance d1 may be about 100 Å to about 400 Å.

When the first distance d1 is within 100 Å (i.e. less than about 100 Å), the hole transport layer HTL and the like may not be sufficiently formed and a light extraction efficiency may be reduced due to the distance from the first resonance distance. When the first distance d1 is about 400 Å or more, surface plasmons formed on the surface of the first electrode 310 may not influence the organic emission layer EML.

Generally, when the surface plasmons are formed, because light occurring in the organic emission layer EML due to the surface plasmons propagates along the surface, the light efficiency may be remarkably reduced, the first electrode 310 on which the plasmons occur is located away from the organic emission layer EML.

In contrast, in one or more embodiments, the organic emission layer EML is located close to the first electrode 310 to cause surface plasmons rather affect the organic emission layer EML.

Excitons formed in the organic emission layer EML may damage the organic emission layer EML during the process of extinction after light is emitted. In one or more embodiments, because the excitons are quenched by the surface plasmons before the excitons damage the organic emission layer EML, the life of the organic emission layer EML may be improved.

That is, because light due to the surface plasmons is extracted in the direction to the second electrode 330 by arranging the metal nanoparticles NP, the light efficiency is increased, and also, the surface plasmons and the organic emission layer EML are located close to each other. Accordingly, the life of the organic emission layer EML is improved.

A distance between the upper surface of the first electrode 310 and the lower surface of the metal reflective layer 333 may be a second distance d2. The second distance d2 may be a second resonance distance based on the intensity of a wavelength emitted in the organic emission layer EML.

The organic emission layer EML may be configured to emit blue light, and the second distance d2 may be about 1500 Å to about 2000 Å. Color purity may be improved and the light efficiency may be increased by adjusting the first distance d1 and/or the second distance d2. Accordingly, a thickness t1 of the hole transport layer HTL may be less than a thickness t2 of the electron transport layer ETL. As an example, the thickness t1 of the hole transport layer HTL may be about 150 Å to about 400 Å, and the thickness t2 of the electron transport layer ETL may be about 400 Å to about 600 Å.

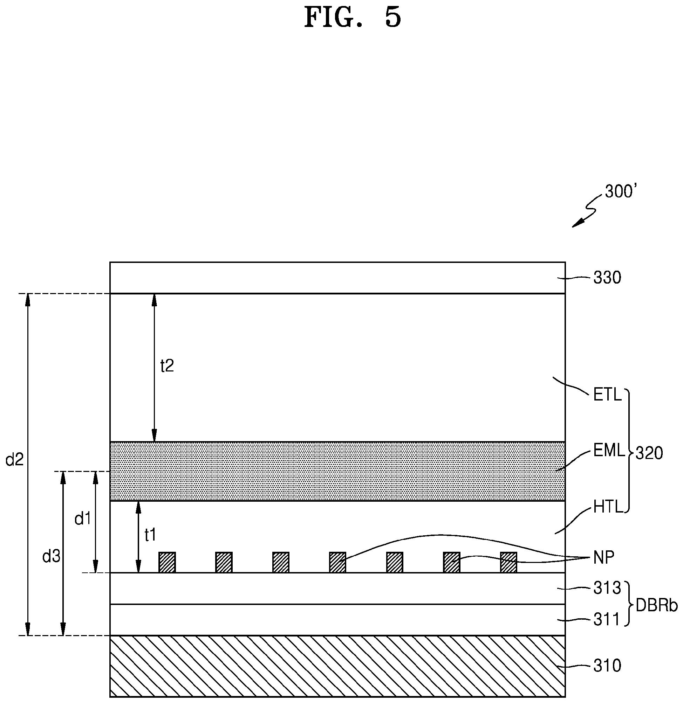

FIG. 5 is a view of a stack structure of an organic light-emitting element 300' according to one or more embodiments. In FIG. 5, the same reference numerals as those of FIG. 4 denote the same members.

That is, the organic light-emitting element 300' according to one or more embodiments includes the first electrode 310 and the second electrode 330 facing each other, the organic emission layer EML located between the first electrode 310 and the second electrode 330, the hole transport layer HTL located between the first electrode 310 and the organic emission layer EML, and the metal nanoparticles NP located on the first electrode 310. A first distance d1 between the organic emission layer EML (e.g., a point at or near the middle of the organic emission layer EML) and the lower surface of the metal nanoparticles NP may be less than a distance between the organic emission layer EML and the second electrode 330.

The first distance d1 may be a first resonance distance based on the intensity of light emitted in the organic emission layer EML. The first distance d1 may be about 100 Å to about 400 Å.

The second electrode 330 may include a reflective metal. As an example, the second electrode 330 may include a thin film including lithium (Li), magnesium (Mg), aluminium (Al), silver (Ag), aluminium-lithium (Al-Li), calcium (Ca), magnesium-indium (Mg-In), magnesium-silver (Mg-Ag), LiF/Al, or LiO₂/Al, and the like, and may include a reflective semi-transmissive electrode. The second electrode 330 may further include a transparent conductive oxide using ITO, IZO, ZnO, or In₂O₃.

A distance between the upper surface of the first electrode 310 and the lower surface of the second electrode 330 may be the second distance d2. The second distance d2 may be the second resonance distance based on the intensity of a wavelength emitted in the organic emission layer EML.

The organic emission layer EML may be configured to emit blue light, and the second distance d2 may be about 1500 Å to about 2000 Å.

A low refractive index layer 311 and a high refractive index layer 313 may be sequentially located between the first electrode 310 and the metal nanoparticles NP. The low refractive index layer 311 may have a refractive index of about 1.2 to about 1.6. In one or more embodiments, the low refractive index layer 311 may include LiF. The high refractive index layer 313 may have a refractive index of about 2 to about 3. The high refractive index layer 313 may include a transparent conductive oxide including ITO, IZO, ZnO, or In₂O₃.

The low refractive index layer 311 and the high refractive index layer 313 may serve as a lower reflective layer DBRb. The lower reflective layer DBRb may be a dispersion Bragg reflective layer. The lower reflective layer DBRb may further include a high refractive index layer and/or a low refractive index layer.

The thickness of the lower reflective layer DBRb may be set by considering a third distance d3. The third distance d3 is a vertical distance between 1/2 of the thickness of the organic emission layer EML and the upper surface of the first electrode 310, and may be the second resonance distance based on the intensity of light emitted in the organic emission layer EML. The third distance d3 may be about 1200 Å to about 1500 Å.

Because the organic light-emitting element 300' introduces the metal nanoparticles NP for extracting light due to the surface plasmons to the front surface, the light efficiency may be increased. Because the metal nanoparticles NP are located in the lower portion of the organic emission layer EML, the organic emission layer EML may not be damaged during the process. In addition, because the organic emission layer EML is located close to the surface plasmons, the life of the organic emission layer EML may be increased.

In addition, because the organic light-emitting element 300' introduces the lower reflective layer DBRb by considering the second resonance distance based on the intensity of light emitted in the organic emission layer EML, the light efficiency may be increased.

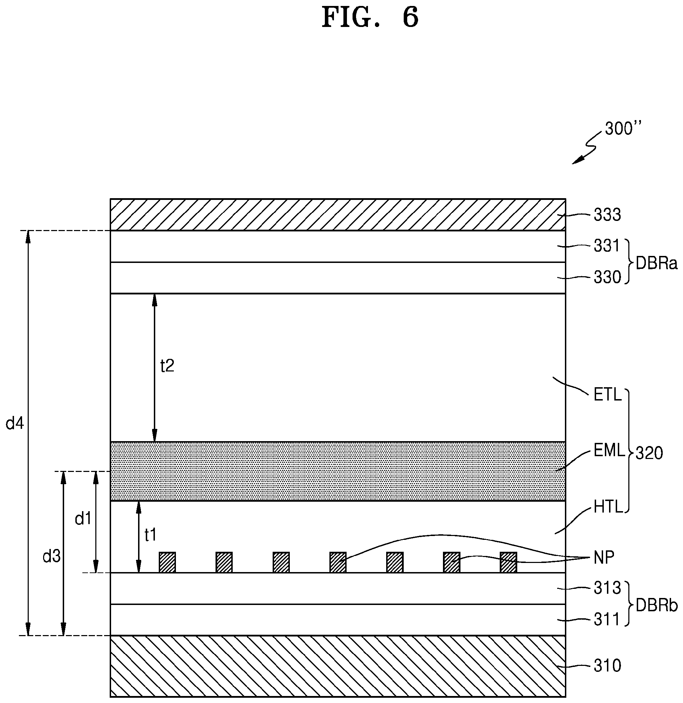

FIG. 6 is a view of a stack structure of an organic light-emitting element 300" according to one or more embodiments. In FIG. 5, the same reference numerals as those of FIG. 4 denote the same members.

That is, an organic light-emitting element 300" according to one or more embodiments includes the first electrode 310 and the second electrode 330 facing each other, the organic emission layer EML located between the first electrode 310 and the second electrode 330, the hole transport layer HTL located between the first electrode 310 and the organic emission layer EML, and the metal nanoparticles NP located on the first electrode 310. In one or more embodiments, a first distance d1 between the organic emission layer EML (e.g., a point at or near the middle of the organic emission layer EML) and the lower surface of the metal nanoparticles NP may be less than a distance between the organic emission layer EML and the second electrode 330.

The first distance d1 may be a first resonance distance based on the intensity of light emitted in the organic emission layer EML. The first distance d1 may be about 100 Å to about 400 Å.

The organic light-emitting element 300" introduces both the lower reflective layer DBRb and the upper reflective layer DBRa.

That is, the low refractive index layer 311 and the high refractive index layer 313 may be sequentially located between the first electrode 310 and the metal nanoparticles NP. The low refractive index layer 311 may have a refractive index of about 1.2 to about 1.6. In one or more embodiments, the low refractive index layer 311 may include LiF. The high refractive index layer 313 may have a refractive index of about 2 to about 3. The high refractive index layer 313 may include a transparent conductive oxide including ITO, IZO, ZnO, or In₂O₃.

The low refractive index layer 311 and the high refractive index layer 313 may serve as the lower reflective layer DBRb. The lower reflective layer DBRb may be a dispersion Bragg reflective layer. The lower reflective layer DBRb may further include a high refractive index layer and/or a low refractive index layer.

The thickness of the lower reflective layer DBRb may be set by considering the third distance d3. The third distance d3 is a vertical distance between 1/2 of the thickness of the organic emission layer EML and the upper surface of the first electrode 310, and may be the second resonance distance based on the intensity of light emitted in the organic emission layer EML. The third distance d3 may be about 1200 Å to about 1500 Å.

A distance between the upper surface of the first electrode 310 and the lower surface of the second electrode 330 may be a fourth distance d4. The fourth distance d4 may be a third resonance distance based on the intensity of a wavelength emitted in the organic emission layer EML.

The organic emission layer EML may be configured to emit blue light, and the fourth distance d4 may be about 2800 Å to about 3200 Å.

Because the organic light-emitting element 300" introduces the metal nanoparticles NP for extracting light due to the surface plasmons to the front surface, the light efficiency may be increased. Because the metal nanoparticles NP are located in the lower portion of the organic emission layer EML, the organic emission layer EML may not be damaged during the process. In addition, because the organic emission layer EML is located close to the surface plasmons, the life of the organic emission layer EML may be increased.

In addition, because the organic light-emitting element 300" introduces the upper reflective layer DBRa and the lower reflective layer DBRb, the light efficiency may be increased.

As described above, because the organic light-emitting element according to the embodiments includes the metal nanoparticles located adjacent to the lower portion of the emission layer, the light efficiency may be increased, and the life may be improved.

The display apparatus according to embodiments may be included in an electronic device. The electronic device according to an embodiment may display a motion image or a static image and may be used as a display screen of not only of portable electronic devices, such as a mobile phone, a smartphone, a tablet personal computer (PC), a mobile communication terminal, an electronic notebook, an electronic book, a portable multimedia player (PMP), a navigation device, and an ultra-mobile PC (UMPC), but also of various products, such as a television (TV), a notebook computer, a monitor, a signboard, the Internet of things (IOT) device, etc. The electronic device according to an embodiment may be used for wearable devices, such as a smart watch, a watch phone, a glasses-type display, and a head-mounted display (HMD). The electronic device according to an embodiment may be used as a center information display (CID) on a gauge of a vehicle or a center fascia or a dashboard of the vehicle; a room mirror display substituting a side-view mirror of a vehicle; or a display disposed on a rear surface of a front seat, as an entertainment device for a backseat of a vehicle.

It should be understood that embodiments described herein should be considered in a descriptive sense only and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the scope as defined by the following claims, with functional equivalents thereof to be included therein.

## Claims

1. An organic light-emitting element (300, 300', 300") comprising:
a first electrode (310) and a second electrode (330) facing each other;
an organic emission layer (EML) between the first electrode (310) and the second electrode (330);
a hole transport layer (HTL) between the first electrode (310) and the organic emission layer (EML); and
metal nanoparticles (NP) above the first electrode (310),
wherein a first distance (d1) between the organic emission layer (EML) and a lower surface of the metal nanoparticles (NP) is less than a distance between the organic emission layer (EML) and the second electrode (330).

2. The organic light-emitting element (300, 300', 300") of claim 1, wherein the first distance (d1) is a first resonance distance with respect to intensity of light generated in the organic emission layer (EML).

3. The organic light-emitting element (300, 300', 300") of claim 1 or claim 2, wherein the first distance (d1) is about 100 Å to about 400 Å.

4. The organic light-emitting element (300) of any one of claims 1 to 3, further comprising a metal reflective layer (333) above the second electrode (330),
wherein a second distance (d2) between an upper surface of the first electrode (310) and a lower surface of the metal reflective layer (333) is about 1,500 Å to about 2,000 Å.

5. The organic light-emitting element (300, 300") of any one of claims 1 to 4, further comprising a low refractive index layer (331) above the second electrode (330), and having a refractive index that is less than a refractive index of the second electrode (330),
wherein the second electrode (330) comprises a transparent conductive oxide, and provides an upper reflective layer (DBRa) together with the low refractive index layer (331).

6. The organic light-emitting element (300, 300', 300") of any one of claims 1 to 5, further comprising an electron transport layer (ETL) between the organic emission layer (EML) and the second electrode (330),
wherein a thickness (t1) of the hole transport layer (HTL) is less than a thickness (t2) of the electron transport layer (ETL).

7. The organic light-emitting element (300', 300") of any one of claims 1 to 6, further comprising a lower reflective layer (DBRb) between the first electrode (310) and the metal nanoparticles (NP).

8. The organic light-emitting element (300', 300") of any one of claims 1 to 7, wherein a distance (d3) between the organic emission layer (EML) and an upper surface of the first electrode (310) is a second resonance distance with respect to intensity of light generated in the organic emission layer (EML).

9. The organic light-emitting element (300") of claim 1 or claim 2, further comprising a metal reflective layer (333) above the second electrode (330),
wherein a distance (d4) between an upper surface of the first electrode (330) and a lower surface of the metal reflective layer (333) is about 2,800 Å to about 3,200 Å.

10. The organic light-emitting element (300") of claim 9, further comprising a lower reflective layer (DBRb) between the first electrode (310) and the metal nanoparticles (NP).

11. An organic light-emitting display apparatus comprising a plurality of pixels (PX) comprising an organic light-emitting element (300, 300', 300") and at least one thin-film transistor (TFT1, TFT2), the organic light-emitting element (300, 300', 300") comprising:
a first electrode (310) and a second electrode (330) facing each other;
an organic emission layer (EML) between the first electrode (310) and the second electrode (330);
a hole transport layer (HTL) between the first electrode (310) and the organic emission layer (EML); and
metal nanoparticles (NP) above the first electrode (310),
wherein a first distance (d1) between the organic emission layer (EML) and a lower surface of the metal nanoparticles (NP) is less than a distance between the organic emission layer (EML) and the second electrode (330).

12. The organic light-emitting display apparatus of claim 11, wherein the first distance (d1) is a first resonance distance with respect to intensity of light generated in the organic emission layer (EML).

13. The organic light-emitting display apparatus of claim 11 or claim 12, further comprising:
(i) a low refractive index layer (331) above the second electrode (330), and having a refractive index that is less than a refractive index of the second electrode (330),
wherein the second electrode (330) comprises a transparent conductive oxide, and provides an upper reflective layer (DBRa) together with the low refractive index layer (331); and/or
(ii) an electron transport layer (ETL) between the organic emission layer (EML) and the second electrode (330),
wherein a thickness (t1) of the hole transport layer (HTL) is less than a thickness (t2) of the electron transport layer (ETL); and/or
(iii) a lower reflective layer (DBRb) between the first electrode (310) and the metal nanoparticles (NP).

14. An electronic device comprising a display apparatus including an organic light-emitting element (300, 300', 300"), wherein the organic light-emitting element (300, 300', 300") comprises:
a first electrode (310) and a second electrode (330) facing each other;
an organic emission layer (EML) between the first electrode (310) and the second electrode (330);
a hole transport layer (HTL) between the first electrode (310) and the organic emission layer (EML); and
metal nanoparticles (NP) above the first electrode (310),
wherein a first distance (d1) between the organic emission layer (EML) and a lower surface of the metal nanoparticles (NP) is less than a distance between the organic emission layer (EML) and the second electrode (330).

15. The electronic device of claim 14, wherein:
(i) the first distance (d1) is a first resonance distance with respect to intensity of light generated in the organic emission layer (MEL); and/or
(ii) the electronic device further comprises a low refractive index layer (331) above the second electrode (330), and having a refractive index that is less than a refractive index of the second electrode (330),
wherein the second electrode (330) comprises a transparent conductive oxide, and provides an upper reflective layer (DBRa) together with the low refractive index layer (331); and/or
(iii) the electronic device further comprises an electron transport layer (ETL) between the organic emission layer (EML) and the second electrode (330),
wherein a thickness (t1) of the hole transport layer (HTL) is less than a thickness (t2) of the electron transport layer (ETL); and/or
(iv) the electronic device further comprises a lower reflective layer (DBRb) between the first electrode (310) and the metal nanoparticles (NP).
